(19) Europäisches Patentamt
European Patent Office
Office européen des brevets

(11) **EP 2 439 309 A1**

(12) **EUROPEAN PATENT APPLICATION**
published in accordance with Art. 153(4) EPC

(43) Date of publication:
**11.04.2012 Bulletin 2012/15**

(51) Int Cl.:
**C23C 14/34** *(2006.01)* **H01B 13/00** *(2006.01)*

(21) Application number: **10783150.5**

(22) Date of filing: **02.06.2010**

(86) International application number:
**PCT/JP2010/003691**

(87) International publication number:
**WO 2010/140362 (09.12.2010 Gazette 2010/49)**

(84) Designated Contracting States:
**AL AT BE BG CH CY CZ DE DK EE ES FI FR GB
GR HR HU IE IS IT LI LT LU LV MC MK MT NL NO
PL PT RO SE SI SK SM TR**

(30) Priority: **03.06.2009 JP 2009134455
13.11.2009 JP 2009260373**

(71) Applicant: **Nikon Corporation
Tokyo 100-8331 (JP)**

(72) Inventors:
• **IWAHORI, Koichiro
Tokyo 100-8331 (JP)**
• **NAKAZUMI, Makoto
Tokyo 100-8331 (JP)**

(74) Representative: **Siegert, Georg
Hoffmann - Eitle
Patent- und Rechtsanwälte
Arabellastrasse 4
81925 München (DE)**

(54) **FILM-FORMED ARTICLE AND METHOD FOR MANUFACTURING FILM-FORMED ARTICLE**

(57) Provided is a manufacturing method for manufacturing a film-formed article by using sputtering to form a film including a constituent element of a target on a substrate. The manufacturing method comprises setting a distance d between the target and the substrate in a range from 0.5 times to 1.5 times a mean free path of the constituent element in the sputtering gas.

*FIG. 2*

**Description**

BACKGROUND

1. TECHNICAL FIELD

The present invention relates to a film-formed article and a method for producing a film-formed article.

2. RELATED ART

Zinc oxide has high transmission of visible light and exhibits conductivity when doped with suitable impurities, and is therefore expected to be used as a material for transparent conductive films. Patent Document 1 discloses a method for manufacturing a zinc oxide film doped with Ga as the impurity.
Patent Document 1: Japancse Patent Application Publication No. H09-87833

However, it is difficult to achieve low resistivity for zinc oxide. One method for lowering the resistivity includes increasing the carrier density to facilitate electrical conduction, but increasing the carrier density also causes the optical absorption due to plasma vibration of the carrier to begin affecting the wavelengths of visible light from the infrared region. This is a problem when the using the zinc oxide in an optical device that utilizes visible light. When the carrier density is approximately $1 \times 10^{21}/cm^3$, the optical absorption due to plasma vibration begins affecting the visible light region from the infrared region. In order to prevent a decrease in the visible light transmission of zinc oxide, it is necessary to lower the resistivity of the zinc oxide while limiting the carrier density to the above value.

SUMMARY

The inventors of the present invention performed a rigorous study to lower the resistivity of zinc oxide by improving the carrier mobility while limiting the carrier density to the above maximum value. According to a first aspect related to the innovations herein, provided is a manufacturing method for manufacturing a film-formed article by using sputtering to form a film including a constituent element of a target on a substrate. The manufacturing method comprises setting a distance between the target and the substrate in a range from 0.5 times to 1.5 times a mean free path of the constituent element in the sputtering gas.

The distance may be in a range from 0.8 times to 1.0 times the mean free path. The mean free path may be the mean free path occurring when zinc atoms move in argon. The distance may be set such that the substrate does not contact the sputtering gas in plasma form.

According to a second aspect related to the innovations herein, provided is a manufacturing method for manufacturing a film-formed article by using sputtering to form a film including a constituent element of a target on a substrate. The manufacturing method comprises, with d [mm] representing distance between the target and the substrate and p [Pa] representing gas pressure between the target and the substrate, forming the film under conditions where d/p is in a range from no less than 600 to no more than 800.

The distance may be in a range from 150 mm to 170 mm. The gas pressure may be in a range from 0.15 Pa to 0.3 Pa. Material forming the target may have a hexagonal crystal structure. The material forming the target may be zinc oxide. Prior to forming the film on the surface of the substrate, the substrate may be irradiated with particles.

According to a third aspect related to the innovations herein, provided is a film-formed article comprising a substrate including organic material and zinc oxide formed on the substrate and having n-type conduction. The zinc oxide has electron mobility greater than or equal to 12 $cm^2/V{\cdot}s$.

According to a fourth aspect related to the innovations herein, provided is a film-formed article comprising a substrate including organic material and zinc oxide formed on the substrate and having n-type conduction. The zinc oxide has an average grain size (column diameter) greater than or equal to 30 nm.

The substrate including the organic material may be a resin substrate, and a softening point of resin of the resin substrate may be in a range from no less than 80°C to no more than 120°C. Here, the softening point refers to the deformation temperature under load, as measured by JIS K7207 (technique A).

The summary clause does not necessarily describe all necessary features of the embodiments of the present invention. The present invention may also be a subcombination of the features described above.

BRIEF DESCRIPTION OF THE DRAWINGS

Fig. 1 schematically shows an exemplary cross section of a film-formed article 100 according to an embodiment of the present invention.

Fig. 2 schematically shows a configuration of a sputter deposition apparatus.
Fig. 3 is a flow chart showing an exemplary process for manufacturing the film-formed article.
Fig. 4 shows the relationship between the carrier mobility and the distance d.
Fig. 5 shows the relationship between the carrier mobility and the pressure p during deposition.
Fig. 6 shows the relationship between the carrier mobility and d/p.
Fig. 7 shows an exemplary cross section of a zinc oxide film observed using a SEM.
Fig. 8 shows the relationship between d/p and an extinction coefficient k.
Fig. 9 shows an exemplary cross section of a zinc oxide film observed using a SEM.
Fig. 10 shows an exemplary cross section of a zinc oxide film observed using a SEM.

DESCRIPTION OF EXEMPLARY EMBODIMENTS

Hereinafter, some embodiments of the present invention will be described. The embodiments do not limit the invention according to the claims, and all the combinations of the features described in the embodiments are not necessarily essential to means provided by aspects of the invention.

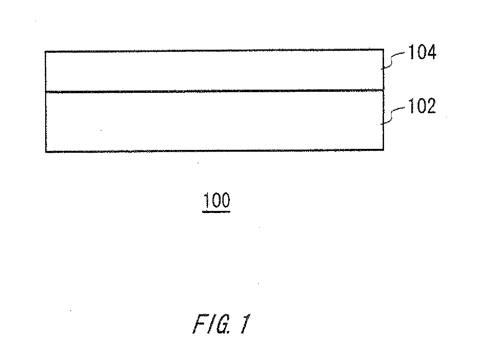

Fig. 1 schematically shows an exemplary cross section of a film-formed article 100 according to an embodiment of the present invention. The film-formed article 100 includes a substrate 102 and a film 104.

The substrate 102 is a substrate suitable for having the film 104 formed on the surface thereof. The substrate 102 has sufficient mechanical strength to serve as a support substrate for the film 104 formed thereon. The substrate 102 may include organic material. A resin substrate is an example of such as substrate including organic material. The softening point of this resin may be between 80°C and 120°C. Examples of the material used in the resin substrate include acryl, epoxy, polycarbonate, polyethylene, and polyester.

The substrate 102 may be a quartz glass substrate, an aluminum substrate, a SiC substrate, a silicon substrate, a GaAs substrate, or a metal substrate, for example. The substrate 102 may be made of single-crystal, polycrystalline, or amorphous material. For example, if the compound film 104 to be formed on the substrate 102 is zinc oxide, the zinc oxide enables easy growth of a film in which the c-axis of a hexagonal crystal is oriented perpendicular to the substrate surface, even for amorphous substrates, and therefore polycrystalline or amorphous material may be used for the substrate 102. In the method for producing the compound film described below, a film is formed using target ions, which have high energy and uniform incidence directions, and therefore a compound film 104 with good crystallinity can be formed even on a polycrystalline or amorphous substrate.

The film 104 may be formed contacting the surface of the substrate 102. The film 104 may be zinc oxide having n-type conduction. The zinc oxide may have electron mobility greater than or equal to 12 $cm^2/V \cdot s$. The zinc oxide may have an average grain size (column diameter) greater than or equal to 30 nm.

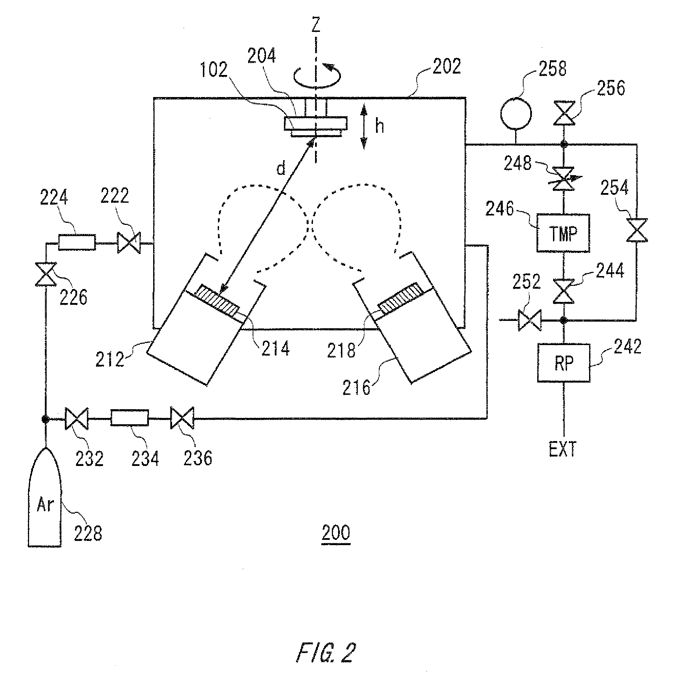

Fig. 2 schematically shows a configuration of a sputter deposition apparatus 200 for producing the film-formed article 100. The deposition apparatus 200 may be a magnetron sputter deposition apparatus. The deposition apparatus 200 includes a deposition chamber 202, a substrate holder 204, a cathode 212, a target 214, a cathode 216, a target 218, a valve 222, a mass flow controller 224, a valve 226, a gas container 228, a valve 232, a mass flow controller 234, a valve 236, a rotary pump 242, a valve 244, a turbomolecular pump 246, a valve 248, a leak valve 252, a valve 254, a leak valve 256, and a vacuum gauge 258.

The deposition chamber 202 is a vacuum apparatus that deposits the film 104 on the substrate 102. The deposition chamber 202 may be connected to a load-lock chamber, not shown. The insertion and removal of the substrate before and after the deposition may be performed by a load-lock system. By adopting the load-lock system, the deposition chamber 202 is kept in a constant vacuum state, thereby greatly reducing the chances of impurities unintentionally mixing with the film.

The substrate holder 204 holds the substrate 102 during deposition. The substrate 102 is arranged on the substrate holder 204 such that the surface of the substrate on which the film 104 is to be grown faces down. The substrate holder 204 may rotate on a Z-axis, which passes vertically through the center of the substrate holder 204, during deposition. As a result of this rotation, the film 104 can be formed uniformly over the surface of the substrate 102.

The substrate holder 204 may be raised and lowered in a prescribed range, shown by h in Fig. 2, in the direction of the Z-axis passing vertically through the center of the substrate holder 204. By raising and lowering the substrate holder 204, the distance between the substrate 102 fixed to the substrate holder 204 and the target 214 or the target 218 can be adjusted. The distance d between the target and the substrate may indicate the distance from the target 214 or the target 218 to the center of the substrate holder 204, for example.

The rotary pump 242, the valve 244, the turbomolecular pump 246, the valve 248, the leak valve 252, the valve 254, the leak valve 256, and the vacuum gauge 258 form a vacuum system for controlling the pressure p within the deposition chamber 202. The vacuum gauge 258 may be a Baratron vacuum gauge. In the initial stage of the vacuum drawing, the valve 254 is opened and the rotary pump 242 is used to perform the vacuum drawing. After a prescribed vacuum degree is reached, the valve 254 is closed, the valve 244 and the valve 248 are opened, and the turbomolecular pump 246 is used to continue the vacuum drawing. During the deposition process, the opening amount of the valve 248 is adjusted to control the pressure p within the deposition chamber 202.

The cathode 212 and the cathode 216 are arranged in the lower portion of the deposition chamber 202. The target 214 and the target 218 are respectively fixed to the cathode 212 and the cathode 216. Fig. 2 shows two cathodes, i.e. the cathodes 212 and 216, but more cathodes can be provided at uniform positions with the cathodes 212 and 216, and each of these additional cathodes may have a target fixed thereto. During the deposition, the plurality of targets may be used for deposition via simultaneous electrical discharge. In Fig. 2, the portions shown by the dotted lines indicate the plasma formed by the discharge.

The material forming the target 214 or the target 218 may have a hexagonal crystal structure. Material having a hexagonal crystal structure enables easy growth of a film in which the c-axis of the hexagonal crystal is oriented perpendicular to the substrate surface, and this results in the film having large grain size and high carrier mobility. Furthermore, the growth rate is high for the same reason. The material forming the target 214 or the target 218 may be zinc oxide. The target 214 or the target 218 may supply impurity elements. The impurity elements may be Al, Ga, or In, for example.

The valve 222, the mass flow controller 224, the valve 226, the gas container 228, the valve 232, the mass flow controller 234, and the valve 236 form the system supplying the sputtering gas. The sputtering gas supply system can supply the sputtering gas near each of the targets. The sputtering gas flow rate can be controlled as desired by the mass flow controller 224 and the mass flow controller 234. The mass flow controller 224 and mass flow controller 234 can modulate the sputtering gas flow rate over time, according to a control signal. In Fig. 2, Ar is used as the sputtering gas, but the sputtering gas may instead be a different noble gas.

During deposition, when power is supplied to the targets while the sputtering gas is being introduced to the deposition chamber 202, glow discharge occurs on the targets, thereby generating particles from the target elements in a variety of states, such as ions, neutral atoms, clusters, and macroparticles. These particles are supplied to the substrate 102 to form the film 104.

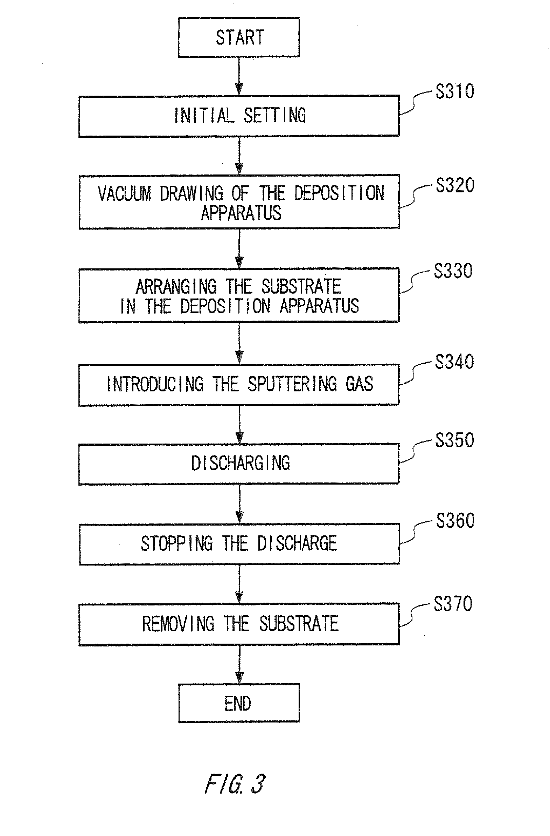

Fig. 3 is a flow chart showing an exemplary process for manufacturing the film-formed article 100. The film-formed article 100 manufacturing method includes a step S310 of performing preliminary settings, a step S320 of vacuum drawing of a deposition apparatus, a step S330 of arranging a substrate in the deposition apparatus, a step S340 of introducing a sputtering gas, a step 5350 of electrical discharge, a step S360 of stopping the discharge, and a step 5370 of removing the substrate.

At step S310 of performing preliminary settings, the target 214 and target 218 are arranged on the cathode 212 and cathode 216. The target 214 and the target 218 may be arranged respectively on the cathode 212 and the cathode 216. For example, if zinc oxide including Al is used as the impurity is used, a target made of zinc oxide may be arranged on the cathode 212 and a target made of Al may be arranged on the cathode 216.

The substrate holder 204 is raised and lowered to adjust the distance d. The distance d may be within a range from 0.5 times to 1.5 times the mean free path of the particles of the constituent elements of the targets in the sputtering gas. As another example, the distance d may be within a range from 0.8 times to 1.0 times the mean free path. The mean free path may be the mean free path occurring when zinc atoms move within argon. The distance d is such that the substrate 102 is not in contact with the sputtering gas in plasma form. The distance d may be within a range from 150 mm to 170 mm.

If film-formed articles 100 are repeatedly manufactured using the same target material and the same distance d, step S310 can be omitted in the repetitions of the manufacturing, from when the target 214 and the target 218 are first set until these targets are completely depleted.

In the manner described above, when forming zinc oxide having n-type conduction, the visible light transmission of the zinc oxide is impaired, and therefore there is a limit on how much the resistivity can be lowered by increasing carrier density. Therefore, the present inventors considered lowering the resistivity of zinc oxide by improving carrier mobility. The mobility of carrier electrons in n-type zinc oxide is affected by scattering of the electrons by the impurities and scattering of the electrons by the grain boundaries. The present inventors attempted to increase the carrier mobility by increasing the grain size of the zinc oxide film and decreasing the grain boundary scattering.

During deposition, the glow discharge generates particles of the target elements having a variety of energies. Among these particles, there are those that reach the substrate 102 but do not have enough energy to sufficiently diffuse in the film 104 being grown. These low-energy particles can be thought of as impeding the crystallization of the film. Therefore, the present inventors thought that, by separating out these particles such that deposition occurs using only the high-energy particles, the film can be formed with high crystallinity, large grain size, and uniform high-quality, thereby increasing the carrier mobility of the film and decreasing resistivity. This result was achieved by increasing the distance d to be greater than the distance usually used in sputtering.

By increasing the distance d to be set near the mean free path of the particles, the low-energy particles repeatedly collide with the other particles causing energy loss and preventing the low-energy particles from reaching the substrate 102, thereby excluding these low-energy particles from the deposition. Only the high-energy particles avoid colliding with other particles within the range of the mean free path and reach the substrate 102 while maintaining high energy, and therefore these high-energy particles are used in the deposition. The high-energy particles can sufficiently diffuse within the film 104 during growth, resulting in uniform crystallization of the film 104.

By increasing the distance d, the substrate 102 is prevented from contacting the plasma, as shown in Fig. 2, thereby eliminating the negative effects of the plasma on the substrate 102. Increasing the distance d results in fewer particles being incident to the substrate 102 at a significant angle, compared to when the substrate 102 is arranged at a position contacted by the plasma, and therefore the majority of the particles used in the deposition are incident at an angle that is nearly perpendicular to the substrate surface. When the angle of incidence is uniform and the incident particles have high energy, growth of a uniform thin film is encouraged.

Normally, during deposition, the substrate can be heated to encourage crystallization of the film. In this case, however, a substrate that is easily deformed when heated, such as a resin substrate, cannot be used. This is a significant impediment when trying to lower the cost and improve the flexibility of the device. By increasing the distance d as described above, the present embodiment can realize a film with high crystallinity, large grain size, and uniform high-quality, without heating the substrate. Furthermore, since the substrate does not come into contact with the plasma, the substrate is almost completely unaffected by the plasma. Therefore, in the present embodiment, a resin substrate that is weak to heat and easily deformed by plasma can be used without problems.

At step S320 of vacuum drawing of the deposition apparatus, the deposition chamber 202 is vacuum drawn. First, the valve 254 is opened and the rotary pump 242 is used to perform the vacuum drawing. After a prescribed vacuum degree is reached, the valve 254 is closed, the valve 244 and the valve 248 are opened, and the turbomolecular pump 246 is used to continue the vacuum drawing. The opening amount of the valve 248 is adjusted to control the internal pressure p within the deposition chamber 202.

The pressure p during deposition may be in a range from 0.15 Pa to 0.3 Pa. When the distance d is expressed in mm and the pressure p is expressed in Pa, the ratio d/p during deposition may be in a range from no less than 600 to no greater than 800. Lowering the pressure p lengthens the mean free path of the particles, which results in more high-energy particles reaching the substrate for the same distance d, thereby enabling formation of a film with high crystallinity.

At step S330 of arranging the substrate in the deposition apparatus, the substrate 102 is arranged in the substrate holder 204. If a load-lock system is used, the substrate 102 can be inserted and removed while maintaining the vacuum degree of the deposition chamber 202. The substrate holder 204 is rotated.

At step S340 of introducing the sputtering gas, a sputtering gas such as Ar is introduced. The sputtering gas supplied near the target 214 is introduced from the gas container 228 while the valve 222 and the valve 226 are open and the mass flow controller 224 controls the flow rate. The sputtering gas supplied near the target 218 is introduced from the gas container 228 while the valve 232 and the valve 236 are open and the mass flow controller 234 controls the flow rate.

At step S350 of electrical discharge, power is supplied to the targets to cause glow discharge on the targets. The glow discharge causes particles to be generated from the target elements in a variety of states, such as ions, neutral atoms, clusters, and macroparticles. These particles are supplied to the substrate 102 to form the film 104. As described above, the distance d and the pressure p are adjusted such that only high-energy particles are used in the deposition, and therefore the film 104 can be formed with high crystallinity and large grain size. As a result, the carrier mobility of the film 104 can be increased and the resistivity can be decreased. The control of the pressure p in the deposition chamber 202 may be performed by adjusting the opening degree of the valve 248.

At step S360 of stopping the discharge, the supply of power to the target 214 and the target 218 is stopped, and the valve 222 and the valve 236 are closed to stop the supply of the sputtering gas.

At step S370 of removing the substrate, the film-formed article 100, which is the film 104 and the substrate 102 on which the film 104 is formed, is removed from the deposition chamber 202. If a load-lock system is used, the film-formed article 100 can be removed while maintaining the vacuum degree of the deposition chamber 202. At this point, the process of manufacturing the film-formed article 100 is finished. If a following film-formed article 100 manufacturing process is to be performed, the above manufacturing process may be repeated from step S330 of arranging the next substrate 102 in the deposition apparatus.

As another example, the film 104 may be aluminum nitride. Aluminum nitride also has a hexagonal crystal structure. In this case as well, an aluminum nitride film can be formed with high crystallinity by setting the distance d to be the mean free path of aluminum.

First Embodiment

Using a deposition apparatus 200 having the configuration shown in Fig. 2, the manufacturing process of Fig. 3 was followed to deposit an n-type zinc oxide film, and the electron mobility of the film was analyzed. A composite quartz glass wafer was used as the substrate 102. During deposition, the substrate 102 was positioned a sufficient distance away from the plasma and was not heated, and therefore the temperature of the substrate remained approximately at room temperature. The raw material target 214 for the film was ZnO, and the impurity target 218 was Al. The sputtering gas was Ar gas.

The distance d was changed in a range from 105 mm to 190 mm when forming the zinc oxide film, and the relationship between the electron mobility and the distance d was analyzed. Furthermore, the pressure p during deposition was changed in a range from 0.22 Pa to 0.5 Pa when forming the zinc oxide film, and the relationship between the electron mobility and the pressure p was analyzed.

A prescribed distance d was set, the composite quartz glass wafer was arranged in the substrate holder 204, and the substrate holder 204 was rotated. The deposition chamber 202 was vacuum drawn, and the vacuum gauge 258 was used to confirm a pressure within the deposition chamber 202 of no more than $1 \times 10^4$ Pa. After this, a power of 200 W and a power of 22.5 W were simultaneously supplied to the ZnO target 214 and the Al target 218 respectively, from a high-frequency power source having a frequency of 13.56 MHz, to form the film via electrical discharge. In previous testing, it was discovered that the electrical resistivity of the ZnO layer is extremely low when the Al doping is performed with the above ratio for the supplied power, and this was used as the ideal doping condition in the apparatus. The sputtering gas was Ar gas supplied at 10 seem near the target 214 and the target 218, using the mass flow controller 224 and the mass flow controller 234. By adjusting the conditions during the deposition, a film was formed for each test condition to have a thickness of 200 nm.

The mean free paths of the target elements in an Ar atmosphere were calculated. When there are A particles and B particles, the mean free path $\lambda_A$ of the A particles can be calculated as shown below.

$$\text{Expression 1: } \lambda_A = 1/[\pi \cdot D_{AB}{}^2 \cdot n_B[1 + \{m_A/m_B\}]^{1/2}]$$

$$\text{Expression 2: } D_{AB} = (D_A + D_B)/2$$

$$\text{Expression 3: } n_B = p/k_B T$$

$D_{AB}$: Average diameter of the A particles and B particles
$D_A$: Diameter of the A particles
$D_B$: Diameter of the B particles
$n_B$: Density of the B particles
$m_A$: Mass of the A particles
$m_B$: Mass of the B particles
p: Pressure during deposition
$k_B$: Boltzmann constant

With the A particles being zinc ions, which are a metal component forming a target, and the B particles being the argon of the sputtering gas, the following data can be substituted into Expressions 1 to 3 to calculate the mean free path of the zinc ions.
$Zn^{2+}$ ion diameter: $D_{Zn} = 1.5 \times 10^{-10}$ m
Ar diameter: $D_{Ar} = 1.4 \times 10^{-10}$ m
$Zn^{2+}$ ion mass: $m_{Zn} = 1.1 \times 10^{-25}$ kg
Ar mass: $m_{Ar} = 6.6 \times 10^{-26}$ kg
Pressure p during deposition: p = 0.22 Pa
Absolute temperature T: T = 300 K
Based on the calculations, the mean free path $\lambda_{Zn}$ of the zinc ions is 0.175 m (175 mm).

Instead of zinc ions, when the A particles are oxygen ions, which are a non-metallic component for forming a target, the following data can be substituted into Expressions 1 to 3 to calculate the mean free path of the oxygen ions.
$O^{2-}$ ion diameter: $D_O = 2.8 \times 10^{-10}$ m
$O^{2-}$ ion mass: $m_O = 2.6 \times 10^{-26}$ kg
Based on the calculations, the mean free path $\lambda_O$ of the oxygen ions is 0.114 m (114 mm).

When the A particles are aluminum ions, which are used for impurity doping when forming a target, the following data can be substituted into Expressions 1 to 3 to calculate the mean free path of the aluminum ions.
$Al^{3+}$ ion diameter: $D_{Al} = 1.1 \times 10^{-10}$ m
$Al^{3+}$ ion mass: $m_{Al} = 4.5 \times 10^{-26}$ kg
Based on the calculations, the mean free path $\lambda_{Al}$ of the aluminum ions is 0.296 m (296 mm).

X-ray analysis was performed on the zinc oxide films, and crystallinity of the zinc oxide films was evaluated from the half-width value of the rocking curve of the ZnO (002) lattice plane. Evaluation was performed on zinc oxide films formed while the pressure was fixed at 0.3 Pa during deposition and the distance d was respectively set to 105 mm, 135 mm, 160 mm, 170 mm, 180 mm, and 190 mm. It was found that, when the distance d is 170 mm, the half-width value of the rocking curve is at a minimum and the crystallinity of the formed film is at a maximum. This distance considerably matches the above value calculated for the mean free path of the Zn ions thought to maximize crystal growth of the ZnO. In other words, if the distance d is set to be near the mean free path of the Zn ions, a zinc oxide film with good crystallinity can be expected to be formed.

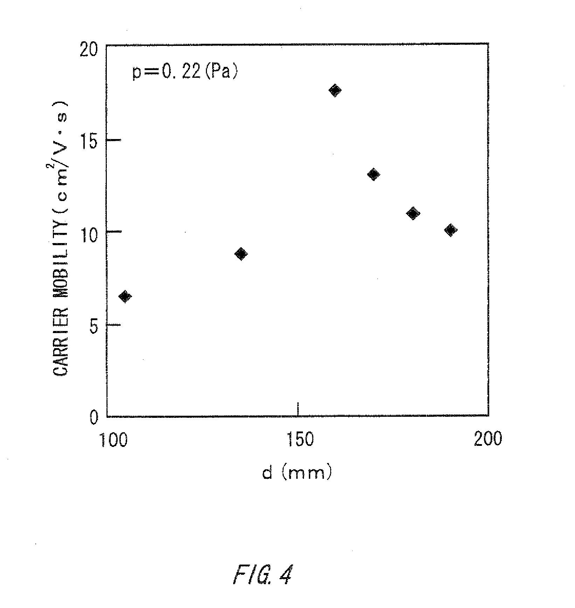

Fig. 4 shows the relationship between the carrier mobility and the distance d. Fig. 4 shows results obtained by measuring the carrier mobility in zinc oxide films formed while the pressure was fixed at 0.22 Pa during deposition and the distance d was respectively set to 105 mm, 135 mm, 160 mm, 170 mm, 180 mm, and 190 mm. The carrier mobility was measured using a hole resistance measurement apparatus. The horizontal axis represents the distance d and the vertical axis represents the carrier mobility of the zinc oxide film.

The carrier mobility increases as the distance d increases from 105 mm, but reaches a maximum value of 17.4 $cm^2/V \cdot s$ at d = 160 mm. When the distance d increases beyond this point, the carrier mobility gradually decreases. In other words, for a prescribed pressure p, there is an optimal distance d at which the carrier mobility has a maximum value. When d is set near this optimal distance, a zinc oxide film with high carrier mobility can be formed without heating the substrate 102.

The reason for this phenomenon is believed to be as follows. At a certain pressure p, increasing the distance d results in low-energy particles being unable to reach the substrate and in a lower ratio of particles being incident to the substrate at an angle. Therefore, the majority of particles actually used in the deposition are high-energy particles that are perpendicularly incident to the substrate, and so the carrier mobility and the crystallinity of the film is increased. However, when the distance d significantly exceeds the mean free path determined by the pressure p, the rate at which the energy of the particles used in the deposition decreases due to collisions with other particles increases. As a result, the diffusion distance into the film of the particles reaching the substrate is decreased, which causes lower crystallinity of the film and lower carrier mobility. Accordingly, there is an optimal relationship between the two parameters of distance d and pressure p.

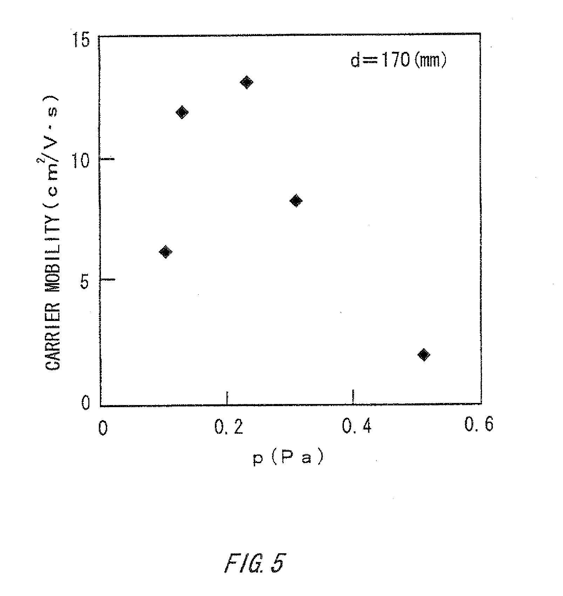

Fig. 5 shows the relationship between the carrier mobility and the pressure p during deposition. Fig. 5 shows results obtained by measuring the carrier mobility in zinc oxide films formed while the distance d was fixed at 170 mm and the pressure p was respectively set to 0.1 Pa, 0.125 Pa, 0.22 Pa, 0.3 Pa, and 0.5 Pa. The horizontal axis represents the pressure p and the vertical axis represents the carrier mobility of the zinc oxide film. The carrier mobility increases as the pressure p gradually decreases from higher pressures, but reaches a maximum value at p = 0.22 Pa. When the pressure p decreases beyond this point, the carrier mobility decreases. In other words, for a prescribed distance d, there is an optimal pressure p at which the carrier mobility has a maximum value. According to the relationship between the distance d and the mean free path determined by the pressure p, when the pressure is low, the crystallinity during growth of the film is lowered.

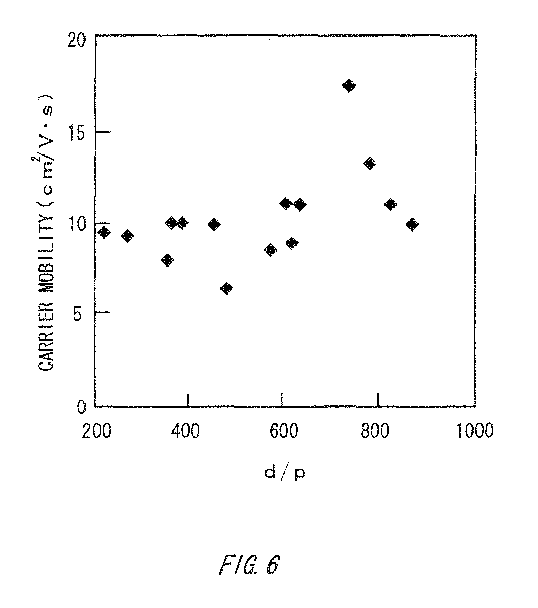

The above measurement results indicate that the carrier mobility is closely related to the distance d and the pressure p, and can have a maximum value for each of these characteristics. Therefore, the present inventors expressed the relationship between the carrier mobility and d/p, which is the ratio between the distance d and the pressure p, as shown in Fig. 6. In Fig. 6, the horizontal axis represents d/p and the vertical axis represents the carrier mobility. As shown in Fig. 6, the carrier mobility tends to increase monotonically as d/p increases, until reaching d/p = 730 mm/Pa, at which point the carrier mobility has a maximum value of 17.4 $cm^2/V \cdot s$. The d and p values at this maximum value are d = 160 mm and p = 0.22 Pa. When d/p increases further, the carrier mobility slowly decreases. Therefore, a zinc oxide film with maximum carrier mobility can be formed by setting the distance d such that the substrate does not contact the plasma and controlling the pressure p such that d/p is near 730 mm/Pa.

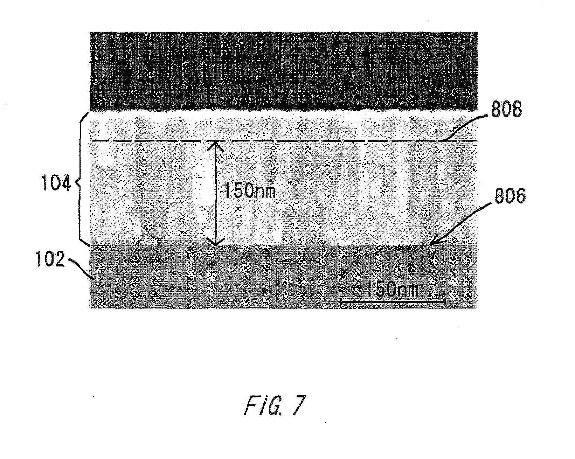

Fig. 7 shows an exemplary cross section of a zinc oxide film observed using a scanning electron microscope (SEM). The crystal of the zinc oxide film 104 is grown in a column perpendicular to the interface 806 between the substrate 102 and the film 104. In the SEM image, a dashed line 808 is drawn at a height of 150 nm from the interface 806. The width of the crystal (column) above the dashed line 808 was scanned, and the average value of this width was calculated as the average grain size (column diameter) of the crystal. A zinc oxide film with a carrier mobility of 12 $cm^2/V \cdot s$ or more has an average column diameter of 30 nm or more.

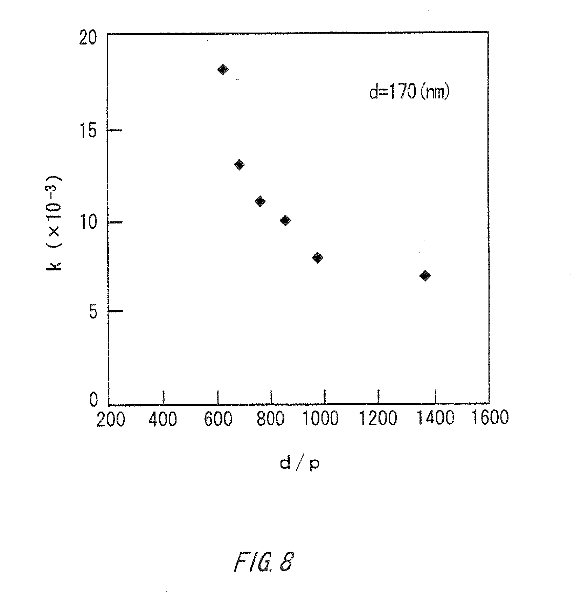

Fig. 8 shows the relationship between d/p and an extinction coefficient k of the zinc oxide film for light with a wavelength of 500 nm. Fig. 8 shows results obtained by measuring films formed while the distance d is fixed at 170 mm, which exhibits the best crystallinity according to the crystal evaluation using the half-width value of the rocking curve as described above, and the pressure p is changed. In Fig. 8, the horizontal axis represents d/p and the vertical axis represents the extinction coefficient k. As shown in Fig. 8, the zinc oxide films formed when d/p was in a range from 600 mm/Pa to 1400 mm/Pa had extinction ratios k for light with a 500 nm wavelength that decreased monotonically as d/p increased. When d/p is greater than or equal to 680 mm/Pa, the extinction coefficient is no greater than 0.013, and this indicates that these zinc oxide films have favorable light transmission.

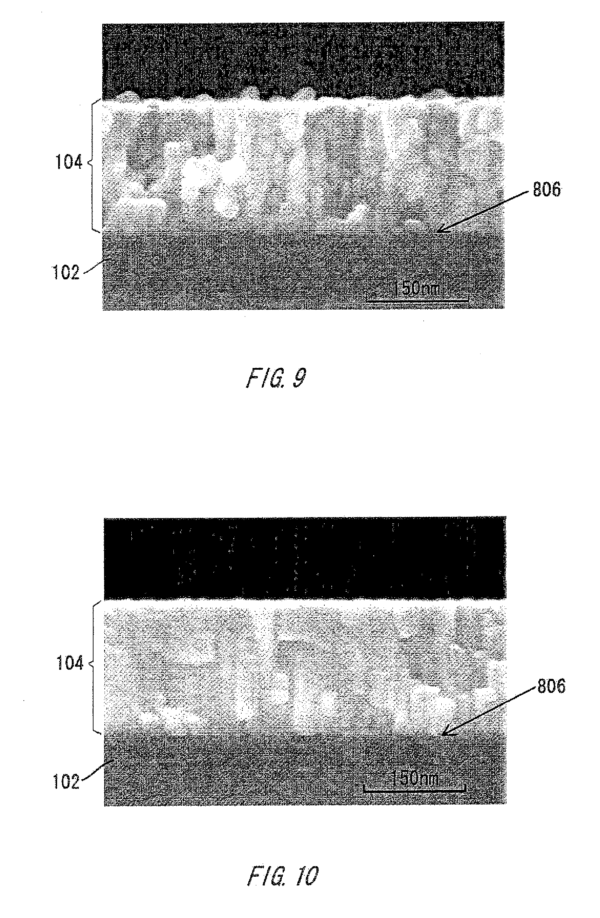

Figs. 9 and 10 are results observed by a SEM for cross sections of zinc oxide films formed respectively with d/p values of 618 mm/Pa and 756 mm/Pa. From these cross section images, the crystallinity of the zinc oxide films can be roughly judged. When compared to the measurement results of Fig. 8, it can be seen that when d/p is 618 mm/Pa, as shown in Fig. 9, the zinc oxide film has poor crystallinity, a high extinction coefficient of 0.018, and low light transmission. When d/p is 756 mm/Pa, as shown in Fig. 10, the zinc oxide film has good crystallinity, a low extinction coefficient of 0.011, and high light transmission. In other words, when d/p is greater than 700 mm/Pa, the resulting zinc oxide film has good crystallinity and high light transmission.

Combining the above with the results regarding carrier mobility shown in Fig. 6, on a condition that 700 mm/Pa < d/p < 900 mm/Pa in the film manufacturing method described above, a zinc oxide film can be formed with high crystallinity, high carrier mobility, and high light transmission, without heating the substrate during deposition. Since the substrate 102 does not contact the plasma, the substrate 102 is almost entirely unaffected by the plasma. Therefore, as shown in the following embodiment, the manufacturing method can be applied to substrates made of resin material that is weak to heat, thereby increasing the usefulness of the film.

Second Embodiment

Using the deposition apparatus 200 having the configuration shown in Fig. 2, the manufacturing method of Fig. 3 was followed to deposit an n-type zinc oxide film on a resin substrate, and the electron mobility of the film was analyzed. An acrylic resin substrate (ACRYLITE (registered trademark) manufactured by Mitsubishi Rayon Co., Ltd) was used as the substrate 102. The softening point of this acrylic resin substrate is 100°C. During deposition, the substrate 102 was positioned a sufficient distance away from the plasma and was not heated, and therefore the temperature of the substrate remained approximately at room temperature, such that the substrate 102 did not exceed the softening point temperature of the acrylic resin substrate and was not damaged.

The raw material target 214 for the film was ZnO, and the impurity target 218 was Al. The sputtering gas was Ar gas.

If the resin substrate were put into a vacuum as-is and used for deposition, dust on the surface of the substrate and degassing from the substrate in the vacuum would lower the adhesive strength of the film formed on the resin substrate. Therefore, in order to prevent a drop in the adhesive strength of the film, the substrate was pre-processed in the manner described below.

First, the substrate 102 was washed in ethanol. The washed substrate 102 was then placed in a separate preparation chamber, in which a reverse sputtering process was performed on the substrate 102. Specifically, in a vacuum state with a pressure of approximately $1 \times 10^{-4}$ Pa, a high-frequency power source with a frequency of 13.56 MHz was used to apply a power of 50 W to the substrate 102 and cause a discharge, and this reverse sputtering was performed for 30 minutes. During this process, the energy particles generated by the discharge irradiate the substrate 102 as ions, for example. This irradiation not only removes dust affixed to the surface of the substrate 102, but also actively encourages degassing of the substrate in the vacuum, thereby restricting the effect of degassing during deposition. The preparation chamber in which the reverse sputtering is performed may be the load-lock chamber of the deposition apparatus 200.

The substrate 102 processed in the above manner was placed in the deposition chamber 202 and deposition was performed. The distance d and pressure p during deposition were set to be 170 mm and 0.22 Pa, which result in a film having high mobility and minimum electrical resistivity according to the results described in the first embodiment. The other deposition conditions were the same as in the first embodiment. The thickness of the film was set to 200 nm by adjusting the deposition time.

Upon analyzing the characteristics of the zinc oxide film formed in this way, it was found that the electric resistivity was $1.8 \times 10^{-3}$ Ω·cm, the carrier density was $2.69 \times 10^{20}$ cm$^{-3}$, and the carrier mobility was 12.5 cm$^2$/V·s. These results indicate that the zinc oxide film formed on the acrylic resin substrate has a high carrier mobility above 12 cm$^2$/V·s, in the same manner as the zinc oxide film formed on the composite quartz glass substrate in the first embodiment. In other words, the results prove that the present embodiment can form a film that has high carrier mobility even on an acrylic resin substrate. Furthermore, these results suggest that a film with the same high carrier mobility could be formed on substrates made of other resin materials whose softening point is above 100°C, such as epoxy, polycarbonate, polyethylene, and polyester.

While the embodiments of the present invention have been described, the technical scope of the invention is not limited to the above described embodiments. It is apparent to persons skilled in the art that various alterations and improvements can be added to the above-described embodiments. It is also apparent from the scope of the claims that the embodiments added with such alterations or improvements can be included in the technical scope of the invention.

The operations, procedures, steps, and stages of each process performed by an apparatus, system, program, and method shown in the claims, embodiments, or diagrams can be performed in any order as long as the order is not indicated by "prior to," "before," or the like and as long as the output from a previous process is not used in a later process. Even if the process flow is described using phrases such as "first" or "next" in the claims, embodiments, or diagrams, it does not necessarily mean that the process must be performed in this order.

**Claims**

1. A manufacturing method for manufacturing a film-formed article by using sputtering to form a film including a constituent element of a target on a substrate, the manufacturing method comprising:

   setting a distance between the target and the substrate in a range from 0.5 times to 1.5 times a mean free path of the constituent element in the sputtering gas.

2. The manufacturing method according to Claim 1, wherein
   the distance is in a range from 0.8 times to 1.0 times the mean free path.

3. The manufacturing method according to Claim 1 or 2, wherein
   the mean free path is the mean free path occurring when zinc atoms move in argon.

4. The manufacturing method according to any one of Claims 1 to 3, wherein the distance is set such that the substrate does not contact the sputtering gas in plasma form.

5. A manufacturing method for manufacturing a film-formed article by using sputtering to form a film including a constituent element of a target on a substrate, the manufacturing method comprising:

   with d [mm] representing distance between the target and the substrate and p [Pa] representing gas pressure between the target and the substrate, forming the film under conditions where d/p is in a range from no less than 600 to no more than 800.

6. The manufacturing method according to Claim 5, wherein
   the distance is in a range from 150 mm to 170 mm.

7. The manufacturing method according to Claim 5, wherein
   the gas pressure is in a range from 0.15 Pa to 0.3 Pa.

8. The manufacturing method according to any one of Claims 1 to 7, wherein material forming the target has a hexagonal crystal structure.

9. The manufacturing method according to Claim 8, wherein
   the material forming the target is zinc oxide.

10. The manufacturing method according to any one of Claims 1 to 9, wherein
    prior to forming the film on the surface of the substrate, the substrate is irradiated with particles.

11. A film-formed article comprising:

    a substrate including organic material; and
    zinc oxide formed on the substrate and having n-type conduction, wherein
    the zinc oxide has electron mobility greater than or equal to 12 $cm^2/V\cdot s$.

12. A film-formed article comprising:

    a substrate including organic material; and
    zinc oxide formed on the substrate and having n-type conduction, wherein
    the zinc oxide has an average grain size (column diameter) greater than or equal to 30 nm.

13. The film-formed article according to Claim 11 or 12, wherein
    the substrate including the organic material is a resin substrate, and

a softening point of resin of the resin substrate is in a range from no less than 80°C to no more than 120°C.

100

FIG. 1

FIG. 2

```
                    ┌─────────────────┐
                    │      START      │
                    └─────────────────┘
                             │
                             ▼
         ┌───────────────────────────────────┐
         │          INITIAL SETTING          │───── S310
         └───────────────────────────────────┘
                             │
                             ▼
         ┌───────────────────────────────────┐
         │  VACUUM DRAWING OF THE DEPOSITION  │───── S320
         │             APPARATUS             │
         └───────────────────────────────────┘
                             │
                             ▼
         ┌───────────────────────────────────┐
         │        ARRANGING THE SUBSTRATE    │───── S330
         │      IN THE DEPOSITION APPARATUS  │
         └───────────────────────────────────┘
                             │
                             ▼
         ┌───────────────────────────────────┐
         │    INTRODUCING THE SPUTTERING GAS │───── S340
         └───────────────────────────────────┘
                             │
                             ▼
         ┌───────────────────────────────────┐
         │            DISCHARGING            │───── S350
         └───────────────────────────────────┘
                             │
                             ▼
         ┌───────────────────────────────────┐
         │        STOPPING THE DISCHARGE     │───── S360
         └───────────────────────────────────┘
                             │
                             ▼
         ┌───────────────────────────────────┐
         │        REMOVING THE SUBSTRATE     │───── S370
         └───────────────────────────────────┘
                             │
                             ▼
                    ┌─────────────────┐
                    │       END       │
                    └─────────────────┘
```

*FIG. 3*

FIG. 4

*FIG. 5*

FIG. 6

FIG. 7

FIG. 8

*FIG. 9*

*FIG. 10*

<table>
<tr><td colspan="2" align="center">**INTERNATIONAL SEARCH REPORT**</td><td colspan="2">International application No.<br>PCT/JP2010/003691</td></tr>
</table>

A.  CLASSIFICATION OF SUBJECT MATTER
*C23C14/34*(2006.01)i, *H01B13/00*(2006.01)i

According to International Patent Classification (IPC) or to both national classification and IPC

B.  FIELDS SEARCHED

Minimum documentation searched (classification system followed by classification symbols)
C23C14/34, H01B13/00

Documentation searched other than minimum documentation to the extent that such documents are included in the fields searched
   Jitsuyo Shinan Koho         1922-1996   Jitsuyo Shinan Toroku Koho   1996-2010
   Kokai Jitsuyo Shinan Koho   1971-2010   Toroku Jitsuyo Shinan Koho   1994-2010

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y | JP 2005-350735 A  (Canon Inc.),<br>22 December 2005 (22.12.2005),<br>paragraphs [0036] to [0041], [0046]; fig. 5<br>(Family: none) | 1,2,4-7<br>3,8-10 |
| Y | JP 2007-056329 A  (Konica Minolta Holdings, Inc.),<br>08 March 2007 (08.03.2007),<br>paragraph [0002]<br>(Family: none) | 3,8-10 |
| Y | JP 2006-257464 A  (Seiko Epson Corp.),<br>28 September 2006 (28.09.2006),<br>paragraph [0014]<br>(Family: none) | 10 |

☒  Further documents are listed in the continuation of Box C.    ☐  See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>   05 August, 2010 (05.08.10) | Date of mailing of the international search report<br>   17 August, 2010 (17.08.10) |
|---|---|
| Name and mailing address of the ISA/<br>   Japanese Patent Office | Authorized officer |
| Facsimile No. | Telephone No. |

Form PCT/ISA/210 (second sheet) (July 2009)

<table>
<tr><td colspan="2"><strong>INTERNATIONAL SEARCH REPORT</strong></td><td>International application No.<br>PCT/JP2010/003691</td></tr>
</table>

C (Continuation).　DOCUMENTS CONSIDERED TO BE RELEVANT

| Category* | Citation of document, with indication, where appropriate, of the relevant passages | Relevant to claim No. |
|---|---|---|
| X | E. FORTUNATO et al., Growth of ZnO:Ga thin films at room temperature on polymeric substrates: thickness dependence, Thin Solid Films, 2003, Vol.442, p.121-126 | 11-13 |
| X | D. H. ZHANG et al., Preparation of transparent conducting ZnO:Al films on polymer substrates by r. f. magnetron sputtering, Applied Surface Science, 2000, Vol.158, p.43-48 | 11,13 |
| X | Yun-Yan LIU et al., Deposition of ZnO thin film on polytetrafluoroethylene substrate by the magnetron sputtering method, Materials Letters, 2007, Vol.61, p.4463-4465 | 12,13 |

Form PCT/ISA/210 (continuation of second sheet) (July 2009)

**INTERNATIONAL SEARCH REPORT**

International application No.

PCT/JP2010/003691

| Box No. II | Observations where certain claims were found unsearchable (Continuation of item 2 of first sheet) |

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| Box No. III | Observations where unity of invention is lacking (Continuation of item 3 of first sheet) |

This International Searching Authority found multiple inventions in this international application, as follows:
  Document 1 (JP 2005-350735 A (Canon Inc.), 22 December 2005 (22.12.2005), paragraphs [0036]-[0041] and [fig. 5]) discloses a method for making the distance between a target and a substrate 0.5 to 1.5 times the average free path of a constituent element in a sputter gas. Therefore, the invention in claim 1 is not novel to the invention in document 1 and does not have a special technical feature. Consequently, the claims include the following four inventions. The invention in claim 1 not having a special technical feature is classified into the invention group 1.
                    (continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**    ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

**INTERNATIONAL SEARCH REPORT**

International application No.

PCT/JP2010/003691

Continuation of Box No.III of continuation of first sheet(2)

Invention group 1: Claims 1-4 and 8-10
A method for making the distance between a target and a substrate 0.5 to 1.5 times the average free path of a constituent element in a sputter gas.

Invention group 2: Claims 5-7
A method for having the ratio d/p at 600 or more but not more than 800, where d is the distance between a target and a substrate, and p is gas pressure.

Invention group 3: Claims 11 and 13
A material having a film formed thereon, wherein the electron mobility of the zinc oxide on a substrate containing an organic material is 12 $cm^2/V \cdot s$ or more.

Invention group 4: Claim 12
A material having a film formed thereon, wherein the average grain diameter (column diameter) of the zinc oxide on a substrate containing an organic material is 30 nm or more.

Form PCT/ISA/210 (extra sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP H0987833 B